Europäisches Patentamt

European Patent Office

Office européen des brevets

(19)

(11) Veröffentlichungsnummer: **0 004 064**
**B1**

(12) ## EUROPÄISCHE PATENTSCHRIFT

(45) Veröffentlichungstag der Patentschrift: **23.06.82**

(51) Int. Cl.³: **H 01 J 37/252**

(21) Anmeldenummer: **79100668.7**

(22) Anmeldetag: **06.03.79**

(54) **Einrichtung an einer Ionenmikrosonde zur Bündelung des Primärionenstrahls.**

(30) Priorität: **07.03.78 AT 1622/78**

(43) Veröffentlichungstag der Anmeldung:
**19.09.79 Patentblatt 79/19**

(45) Bekanntmachung des Hinweises auf die Patenterteilung:
**23.06.82 Patentblatt 82/25**

(84) Benannte Vertragsstaaten:
**DE FR GB**

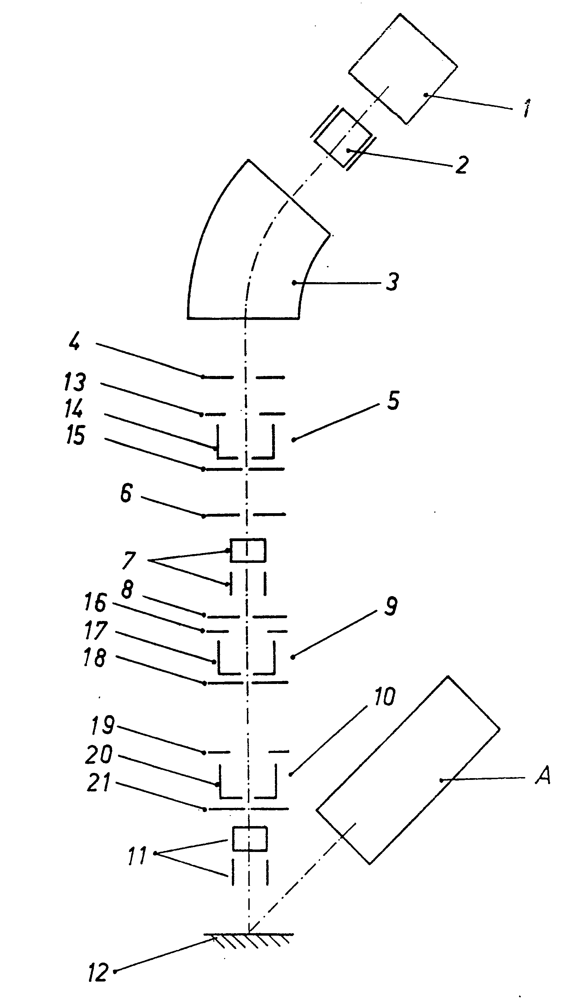

(56) Entgegenhaltungen:
**DE - A - 2 412 675**
**US - A - 3 517 191**
**RADIATION EFFECTS, London, Vol. 28, Nr. 3—**
**4, Seiten 183—187, 1976, COLLIGON und**
**FULLER: Secondary ion Studies of the Range**
**Profiles of implanted Ions" Figur 1 ; Seite 184**

(73) Patentinhaber: **Österreichisches**
**Forschungszentrum Seibersdorf Ges. m. b. H.**
**Lenaugasse 10**
**A-1082 Wien (AT)**

(72) Erfinder: **Rüdenauer, Friedrich, Prof.Dr.**
**Nordmanngasse 9**
**A-1210 Wien (AT)**
Erfinder: **Steiger, Wolfgang, Dr.**
**Anton Kriegergasse 185**
**A-1238 Wien (AT)**

(74) Vertreter: **Reitstötter, Josef, Prof.Dr. Dr. et al,**
**Bauerstrasse 22 P.O. Box 780**
**D-8000 München 43 (DE)**

### Einrichtung an einer Ionenmikrosonde zur Bündelung des Primärionenstrahls

Die Erfindung bezieht sich auf eine Einrichtung un einer Ionenmikrosonde zur Bündelung des Primärionenstrahls.

Um möglichst genaue Analysenergebnisse zu erhalten, ist es bei Ionenmikrosonden erforderlich, daß der auf die zu untersuchende Probe auftreffende Primärionenstrahl möglichst stark gebündelt ist und eine hohe Stromstärke aufweist und außerdem, daß mit dem Primärionenstrahl keine Fremdatome und Fremdmoleküle auf die Probenoberfläche treffen können. Neben einer leistungsfähigen Ionenquelle ist somit die Bündelung des Primärionenstrahls und ein niedriger Restgasdruck in der Umgebung der Probe von hoher Bedeutung.

Bei einer Ionensonde ist bereits eine Einrichtung zur Bündelung des Primärionenstrahls bekannt geworden, bei dem der aus der Primärionenquelle austretende Strahl vorerst ausgerichtet und sodann einer magnetischen Sektorfeldlinse zugeführt wird, wonach durch eine Massenselektionsblende lediglich die erwünschten Ionen aus dem Strahl durchtreten können, worauf der Strahl in die Objektivlinse gelangt und über Ablenkplatten auf den ausgewählten Bereich der Probe gerichtet ist. Eine derartige Einrichtung hat jedoch den Nachteil, daß die Auftrefffläche des Strahls auf der Probe relativ groß ist, so daß nur größere Bereiche der Probe untersucht werden können. Gleichzeitig ist die Stromstärke relativ gering und die Druckdifferenz zwischen dem Bereich der Probe und der Primärionenquelle ist relativ niedrig.

Es ist bekannt zur Druckverminderung zwischen der Primärionenquelle und der Probe noch eine weitere enge Blende vorzusehen Nachteilig an den zwei verschiedenen Ausführungsformen ist, daß bei der einen zwar ein besonders kleiner Strahlendurchmesser erreicht werden kann, wobei jedoch ohne mechanische Änderung eine Variierung des Strahlendurchmessers eines stromstarken Primärionenstrahl nicht möglich ist. Bei der anderen Ausführung ist nur ein hoher Primärstrom bei großen Flecken möglich, jedoch eine Feinbündelung zu kleinen Fleckdurchmessern nicht durchführbar.

In der US—Patentschrift 3 517 191 wird eine Ionenmikrosonde gezeigt, bei der eine Kondensorlinse zwischen der Sektorfeldlinse und der Objektivlinse angeordnet ist. Diese Anordnung ermöglicht es, den in der Sektorfeldlinse gereinigten Ionenstrahl mit dem Durchmesser der Öffnung der Ionenquelle so auf die zu untersuchende Probe zu projizieren, daß die Verkleinerung des Brennfleckens gegenüber der Ionenquellenöffnung innerhalb eines gewissen Bereiches in etwa auf ein hundertstel Millimeter frei wählbar erfolgt. Der Vorteil dieser Anordnung gegenüber einer solchen ohne Kondensorlinse besteht darin, daß eine kompaktere Bauweise bei einer in etwa vorgegebenen Verkleinerung ermöglicht wird und gleichzeitig durch eine variabel einstellbare Verkleinerung die Größe des Brennfleckens auf der Probe den Analyseerfordernissen angepaßt werden kann. Die Nachteile der Erfindung bestehen jedoch darin, daß das aus der Ionenquelle ausströmende Gas in die gemeinsame Vakuumkammer, in welcher der Fokussierungsteil und der Probenteil untergebracht sind, ausströmen kann, wodurch das für hoch qualifizierte Probenuntersuchungen erforderliche Ultrahochvakuum im Bereich der Probe nicht aufrechterhalten werden kann. Für den Fall, daß man zur Verbesserung des Vakuums im Bereich der Probe die Vakuumkammer durch eine feine Blende (z.B. 0,2 bis 0,3 mm) an der Stelle des Fokussierungspunktes in zwei voneinander getrennte Kammerteile unterteilt, wäre es bei der Anordnung gemäß der US—PS durch die geometrische Anordnung der Blende bedingt, daß nur für eine bestimmte Verkleinerung die maximale Ionenstromstärke ausgenützt werden kann. Bei einer Änderung der Verkleinerung durch Änderung der frei wählbaren Brennweite der Kondensor- und Objektivlinse würde sich der Fokussierungspunkt geometrisch verschieben und durch die Blende der Ionenstrom verringert werden, sofern nicht eine geometrische Verschiebung der Blende in dem jeweiligen neuen Fokussierungspunkt erfolgen würde. Eine derartige Verschiebung mit der hierzu erforderlichen Präzision unter dem notwendigen Vakuum würde jedoch einen sehr großen technischen Aufwand erfordern.

Der erfindungsgemäßen Einrichtung liegt die Aufgabe zugrunde, durch eine entsprechende Anordnung von Blenden und Fokussiereinrichtungen das Einströmen von Restgasen in die Kammer, welche ein Ultrahochvakuum aufweist, zu verhindern, wobei eine geometrische Verstellbarkeit dieser Mittel unnötig sein soll. Weiterhin soll der Ionenstrahl eine konstante Stärke aufweisen, um eine gleichbleibende Analyseempfindlichkeit zu gewährleisten und soll auch bei hohem Primärstrom einen geringen Durchmesser des kleinsten einstellbaren Fokussierpunktes aufweisen.

Die erfindungsgemäße Einrichtung au einer Ionenmikrosonde zur Bündelung des Primärionenstrahls auf einen bestimmten Bereich einer Materialprobe mit in Richtung des Strahlengangs gesehen einer Primärionenquelle, einer elektromagnetischen Sektorfeldlinse, einer Massenselektionsblende, einer elektrostatischen Objektivlinse und Ablenkelektroden zur Ablenkung des Primärionenstrahls, die vor oder nach der Objektivlinse angeordnet sind, besteht im wesentlichen darin, daß zwischen der Sektorfeldlinse und der Objektivlinse zwei elektrostatische Kondensorlinsen angeordnet sind, die voneinander unterschiedliche laterale Vergrößerung aufweisen, und daß eine Blende zwischen den Kondensorlinsen angeordnet ist. Durch die Anordnung der beiden elektrostatischen Kondensorlinsen kann zwar eine Größenreduktion des Primärionenteils einer Mikrosonde im allgemeinen nicht erreicht werden, jedoch können hohe Stromstärken auf der Materialprobe erhalten werden, wobei gleichzeitig eine besonders enge Bündelung erreicht werden kann und verschiedene Brennfleckgrößen auf der Probe möglich sind, so daß eine besonders leichte Anpassung an die jeweiligen Analysenerfordernisse durchgeführt werden kann.

Weisen die Kondensorlinsen und/oder die Objektivlinse drei Blenden auf, wobei der Abstand der objektnäheren von der mittleren kleiner ist als der der mittleren von der objektferneren Linse, so kann eine besonders gute Fokussierung des Primärionenstrahls auf der zu untersuchenden Materialprobe erreicht werden.

Ist eine Blende zwischen den Kondensorlinsen angeordnet, so wird der Druckreduzierungseffekt wesentlich erhöht, so daß die Stromstärke auch bei kleinem Flächendurchmesser besonders erhöht werden kann, womit eine genauere quantitative Auswertung des Analysenergebnisses ermöglicht wird.

In der erfindungsgemäßen Einrichtung kann somit ohne mechanische Änderung bei gleich stark reduziertem Druck in der Probenumgebung ein fein fokussierter Primärionenstrahl mit relativ niedriger Stromstärke und ein Strahl hoher Stromstärke mit entsprechend vergrößertem Durchmesser erhalten werden.

Im folgenden wird die Erfindung anhand der Zeichnung näher erläutert.

In der Zeichnung ist ein Mikroanalysator schematisch dargestellt, wobei lediglich der Primärionenteil detailliert dargestellt ist, wohingegen der Sekundärionenteil, der nicht Gegenstand der Erfindung ist, durch den Teil A symbolisiert wird.

Aus der Primärionenquelle 1 tritt ein Ionenstrahl aus, der durch vier Korrekturplatten (2) ausgerichtet wird. Der ausgerichtete Strahl tritt sodann in die Sektorfeldlinse 3 ein, die entweder aus einem homogenen oder einem inhomogenen magnetischen Sektorfeld bestehen kann. Der Strahl gelangt sodann zur Massenselektionsblende 4, durch die lediglich die erwünschten Ionen treten. Der Strahl tritt sodann in die erste Kondensorlinse 5 ein, die ein reelles verkleinertes Abbild der Massenselektionsblende 4 bzw. der Emissionsöffnung der Ionenquelle 1 entwirft. Ist die Lateralvergrößerung der Linse 5 besonders niedrig, so entsteht ein stark verkleinertes Zwischenbild, das durch die folgenden Linsen 9 und 10 weiter verkleinert und auf die Probenoberfläche fokussiert wird.

Damit entsteht ein besonders scharf gebündelter Ionenstrahl mit wenigen $\mu$m Durchmesser, dessen Stromstärke jedoch in Folge der damit verbundenen Winkelausweitung relativ niedrig ist. Wird die Lateralvergrößerung der Linse 5 größer gewählt, und zwar so, daß das Abbild der Blende 4 bzw. der Emissionsöffnung der Ionenquelle in der Mitte der Druckreduzierungsblende 6 liegt, dann kann durch diese Blende der maximale Ionenstrom treten. Die durch die Linsen 5, 9 und 10 gegebene Totalvergrößerungen des Ionenstrahls, die sich aus dem Produkt der Einzelvergrößerungen ergibt, wird größer als im zuvorangeführten Fall sein.

Der Strahl tritt sodann durch die Blende 6, die als Differenzdruckblende fungiert, durchläuft die Strahlenverschiebungselektroden 7, durch welche der Primärionenstrahl parallel zu sich versetzt werden kann tritt anschließend durch die Referenzstromelektrode 8 in die zweite Kondensorlinse 9 ein, die das von der Linse 5 entworfene Bild in ein verkleinertes Zwischenbild fokussiert gelangt sodann zur Objektivlinse 10 und wird darauf durch die Ablenkelektroden 11 auf einen bestimmten Punkt der Probe 12 gerichtet. Die von der Probe emittierten Sekundärionen treten in die Analyseneinrichtung A ein und werden dort in an sich bekannter Art analysiert.

Die Brennweiten bzw. Lateralvergrößerungen der Linsen 5, 9 und 10 werden so aufeinander abgestimmt, daß bei einem fixen Abstand zwischen Ionenquelle und Probe und einer variablen Gesamtvergrößerung dieser drei Linsen dennoch der kleinste Strahlendurchmesser immer am Ort der Probe erzielt werden kann.

Wie aus der Zeichnung ersichtlich, sind die einzelnen Blenden 13, 14 und 15 der ersten Kondensorlinse und die Blenden 16, 17 und 18 der zweiten Kondensorlinse und die Blenden 19, 20 und 21 der Objektlinse so angeordnet, daß der Abstand der jeweils objektnäheren Blende 15, 18 bzw. 21 zur mittleren Blende 14, 17 und 20 kleiner ist als jener der mittleren zur objektferneren Blende 13, 16 und 19. Durch diese Anordnung ist eine sehr gute Fokussierung des Primärionenstrahls auf die Probe möglich.

**Patentansprüche**

1. Einrichtung un einer Ionenmikrosonde zur Bündelung des Primärionenstrahls auf einen bestimmten Bereich einer Materialprobe, mit in Richtung des Strahlengangs gesehen einer Primärionenquelle (1), einer elektromagnetischen Sektorfeldlinse (3), einer Massenselektionsblende (4), einer elektrostatischen Objektivlinse (10) und Ablenkelektroden (11) zur Ablenkung des Primärionenstrahls, die vor oder nach der Objektivlinse (10) angeordnet sind, dadurch gekennzeichnet, daß zwischen der Sektorfeldlinse (3) und der Objektivlinse (10) zwei elektrostatische Kondensorlinsen (5 und 9) angeordnet sind, die voneinander unterschiedliche laterale Vergrößerungen aufweisen, und daß eine Blende (6) zwischen den Kondensorlinsen (5 und 9) angeordnet ist.

2. Einrichtung nach Anspruch 1, dadurch gekennzeichnet, daß die Kondensorlinsen (5 und 9) und/oder die Objektivlinse (10) drei Blenden aufweisen, wobei der Abstand der objektnäheren von der mittleren kleiner als der der mittleren von der objektfernen Blende ist.

## Claims

1. Apparatus in an ion microprobe for concentrating the primary ion beam upon a defined area of a test-material, comprising in beam-direction a primary ion source (1), an electromagnetic sector lense (3), a mass selecting diaphragm (4), an electrostatic objective lense (10), and deflection electrodes (11) for deflecting the primary ion beam, said electrodes (11) being arranged before or after the objective lense (10), characterized in that in between of the sector lense (3) and the objective lense (10) two electrostatic condenser lenses (5 and 9) are arranged having different lateral magnification, and in that a diaphragm (6) is arranged in between of said condenser lenses (5 and 9).

2. Apparatus according to claim 1, characterized in that the condenser lenses (5 and 9) and/or the objective lense (10) comprise three diaphragms, wherein the distance between the diaphragm close to the test-material and the middle-diaphragm is shorter than that between the middle-diaphragm and the diaphragm remote of the test-material.

## Revendications

1. Dispositif permettant de concentrer le faisceau primaire dans une microsonde à faisceau ionique sur une zone déterminée d'une éprouvette de matériau, comportant, d'amont en aval suivant la marche des ions du faisceau, une source d'ions primaires (1), une lentille électromagnétique de champ à secteur (3), un diaphragme de sélection de masse (4), une lentille électrostatique d'objectif (10) et des électrodes déviatrices (11) disposées en amont ou en aval de ladite lentille d'objectif (10) pour dévier le faisceau primaire, caractérisé par le fait que deux lentilles électrostatiques de concentration (5 et 9) sont placées entre la lentille de champ (3) et la lentille d'objectif (10), lesdites lentilles de concentration présentent des agrandissements latéraux différents, et qu'un diaphragme (6) est disposé entre ces deux lentilles (5, 9).

2. Dispositif selon la revendication 1, caractérisé par le fait que chacune des lentilles de concentration (5 et 9) et/ou la lentille d'objectif (10) présentent trois diaphragmes, la distance du diaphragme le plus proche de l'objectif au diaphragme médian étant inférieure à celle qui sépare ledit diaphragme médian de celui qui se trouve le plus loin dudit objectif.

0 004 064